# EUROPEAN PATENT SPECIFICATION

(11) **EP 3 579 396 B1**
(45) Date of publication and mention of the grant of the patent: **19.10.2022**
(21) Application number: 18748101.5
(22) Date of filing: 25.01.2018
(51) Int. Cl.: H02M 7/48, H05K 7/14, H05K 7/20

(54) **POWER CONVERSION DEVICE**
STROMWANDLUNGSVORRICHTUNG
DISPOSITIF DE CONVERSION DE PUISSANCE

(30) Priority: 31.01.2017 JP 2017014977
(43) Date of publication of application: 11.12.2019
(73) Proprietor: Hitachi, Ltd., Chiyoda-ku Tokyo 100-8280 (JP); Hitachi Building Systems Co., Ltd., Tokyo 101-8941 (JP)
(72) Inventor: MAE, Kentarou, Tokyo 100-8280 (JP); ONUMA, Emi, Hitachinaka-shi, Ibaraki 312-8506 (JP); KAWAMURA, Tomoyuki, Tokyo 100-8280 (JP); SHIRATO, Kazuyuki, Hitachinaka-shi, Ibaraki 312-8506 (JP)
(74) Representative: Mewburn Ellis LLP
(86) International application number: PCT/JP2018/002315
(87) International publication number: WO 2018/143053

(56) References cited:
- EP-A1- 3 229 570
- WO-A1-2011/004450
- JP-A- H0 311 924
- JP-A- H06 225 548
- JP-A- 2009 044 842
- JP-A- 2012 157 161
- JP-A- 2015 162 920
- JP-A- 2015 198 545
- JP-B2- 5 269 259
- US-A1- 2012 044 640

## Description

### Technical Field

The present invention relates to a power conversion device including power semiconductors.

### Background Art

Power conversion devices using power semiconductors are indispensable to stably supply power or drive and control electrically powered devices and are variously used in fields including the railway field, the automotive field, the industrial field, and the aviation field. Traditionally, such power conversion devices have been requested to be downsized and various downsizing techniques have been developed.

A power conversion device is composed of not only a power semiconductor but also various built-in devices such as a cooler, a capacitor, and a transformer. It is effective to downsize the built-in devices in order to downsize the whole power conversion device. In addition to this, when the built-in devices can be efficiently arranged in the power conversion device, the power conversion device can be further downsized.

In order to determine the arrangement of the built-in devices, a method of cooling the power semiconductor should be initially considered. As the cooling method, there is a water-cooling method of circulating cooling water to radiate heat or an air-cooling method of supplying cooling air to a cooling fin to radiate heat.

When the water-cooling method is used, the volume of the cooler located near the power semiconductor is small and a unit including the power semiconductor is small. However, a device for circulating cooling water is required and a large region for storing the device needs to be prepared. When the air-cooling method is used, the volume of the cooler located near the power semiconductor is large and the unit including the power semiconductor is larger compared with the water-cooling method. However, a device for supplying cooling air to the cooling fin is not required, or even if the device is required, the device is smaller compared with the air-cooling method.

As described above, the water-cooling method and the air-cooling method have characteristics opposite to each other in terms of the arrangement of the devices. The water-cooling method or the air-cooling method needs to be selected based on requested specifications. It is desirable that the unit including the power semiconductor be small regardless of a method selected from among the methods. As conventional techniques for downsizing the unit including the power semiconductor, there are JP 2008-245451 and JP Hei 11-8982.

US 2012/044640 A1 discloses a power converter which is installed in a casing attached beneath the floor of an electric vehicle. JP H0 6225 548 refers to an inverter device for electric rolling stock.

### Summary of Invention

### Technical Problem

The present inventors have obtained the following idea as a result of strictly considering the downsizing of a whole power conversion device including power semiconductors.

Each of the conventional techniques pays attention to the downsizing of a unit including a power semiconductor and indicates a configuration in which as few devices as possible are arranged, except for the power semiconductor and a heat radiating plate. The power semiconductor is a device that is considered to fail with the highest probability in the power conversion device. Thus, when the unit including the power semiconductor is downsized, there is an advantage that the unit is easily replaced upon a failure.

When the unit including the power semiconductor is downsized and a smoothing capacitor and a gate drive board are arranged away from the power semiconductor, a wiring electrically connecting the smoothing capacitor to the gate drive board is long and wiring inductance increases . When the wiring inductance increases, a surge voltage increases with this increase and may adversely affect an operation of a power conversion circuit.

An object of the present invention relates to the downsizing of a whole power conversion device including power semiconductors, smoothing capacitors, and gate drive boards.

### Solution to Problem

The invention is defined by the features of claim 1. Further embodiments are defined in the dependent claims A power conversion device is provided in which a plurality of smoothing capacitors are arranged on both sides of a heat radiating plate having both surfaces on which a plurality of power semiconductors are arranged in a casing and in which gate drive boards for receiving and outputting a control signal from and to the plurality of power semiconductors are arranged under the power semiconductors, the heat radiating plate, and the smoothing capacitors in the casing.

### Advantageous Effects of Invention

According to the present invention, while a circuit operation is stabilized, insulation reliability is improved, and the manufacturing cost is reduced, a compact power conversion device can be provided.

### Brief Description of Drawings

Fig. 1 shows a basic structure of a power conversion device according to a first embodiment.
Fig. 2 shows a power conversion circuit of the power conversion device according to the first embodiment.
Fig. 3 shows the arrangement of a heat radiating plate and power semiconductors when viewed from a side indicated by arrows A in Fig. 1.
Fig. 4 shows device arrangement viewed from a side indicated by an arrow B in Fig. 1.
Fig. 5 shows device arrangement viewed from a side indicated by an arrow C in Fig. 1.
Fig. 6 shows device arrangement viewed from a side indicated by arrows D in Fig. 1.
Fig. 7 shows a configuration of each of relay boards installed in the power conversion device according to the first embodiment.
Fig. 8 shows the arrangement of gate drive boards in a power conversion device according to a second embodiment.
Fig. 9 shows a basic structure of a power conversion device according to a third embodiment.
Fig. 10 shows a basic structure of a power conversion device according to a fourth embodiment.
Fig. 11 shows a power conversion circuit of a power conversion device according to a fifth embodiment.
Fig. 12 shows the arrangement of power semiconductors and gate drive boards in the power conversion device according to the fifth embodiment.
Fig. 13 shows the arrangement of power semiconductors and gate drive boards in a power conversion device according to a sixth embodiment.
Fig. 14 shows the arrangement of a heat radiating plate and power semiconductors in a power conversion device according to a seventh embodiment.

### Description of Embodiments

An embodiment discloses a three-phase or single-phase power conversion device in which power semiconductors that constitute phases and upper and lower arms of a power conversion circuit on either or both of surfaces of a heat radiating plate held in a casing are installed, electrically connected to smoothing capacitors via a P-pole wiring and an N-pole wiring, and electrically connected to gate drive boards via a G-pole wiring and an E-pole wiring and in which the gate drive boards receive and output a control signal related to a control logical unit via a relay board. The smoothing capacitors are held in the casing on both sides or one side of the heat radiating plate in the casing, the gate drive boards are held in the casing on both sides or one side of the heat radiating plate in the casing, and arranged under the heat radiating plate, the power semiconductors, the smoothing capacitors, the P-pole wiring, and the N-pole wiring.

In addition, the embodiment discloses a power conversion device in which a plurality of power semiconductors that constitute upper and lower arms of phases of a power conversion circuit, a heat radiating plate having both surfaces on which the plurality of power semiconductors are installed, a plurality of smoothing capacitors electrically connected to the plurality of power semiconductors, and a plurality of gate drive boards for receiving and outputting a control signal from and to the plurality of power semiconductors are arranged in a casing. The plurality of smoothing capacitors are arranged on both sides of the heat radiating plate. The gate drive boards are arranged under the power semiconductors, the heat radiating plate, and the smoothing capacitors.

In addition, the embodiment discloses the power conversion device in which a water-cooling pipe is attached to the heat radiating plate and cooling water flows into and out of the heat radiating plate.

In addition, an embodiment discloses a power conversion device in which a cooling fin is attached to a heat radiating plate and cooling air crosses the cooling fin.

In addition, the embodiment discloses the power conversion device in which the cooling fin is attached to the heat radiating plate and natural convection occurs around the cooling fin.

According to the invention, the power conversion device in which the gate drive boards are divided into high-potential portions and low-potential portions, the high-potential portions are arranged on a side closer to the power semiconductors, and the low-potential portions are arranged on a side farther away from the power semiconductors.

In addition, the embodiment discloses the power conversion device in which the plurality of gate drive boards are held on both surfaces of a plate material.

In addition, an embodiment discloses a power conversion device in which insulating members are arranged between a plurality of gate drive boards and a plate material and between the gate drive boards adjacent to each other.

In addition, the embodiment discloses the power conversion device in which the gate drive boards have connectors electrically connected to a relay board, the relay board has a plurality of connectors electrically connected to the plurality of gate drive boards, and the plurality of gate drive boards are collectively connected to the relay board.

In addition, the embodiment discloses the power conversion device in which the relay board is held by the casing.

In addition, an embodiment discloses a power conversion device in which upper and lower arms of a power conversion circuit are constituted by a single power semiconductor.

In addition, the embodiment discloses the power conversion device in which casings of the smoothing capacitors are molded with resin.

In addition, each of the embodiments discloses an electric vehicle including a power conversion device.

Hereinafter, the aforementioned and other new characteristics and effects of the present invention are described with reference to the accompanying drawings. The drawings are exclusively used to understand the invention and do not limit the scope of the appended claims.

### First Embodiment

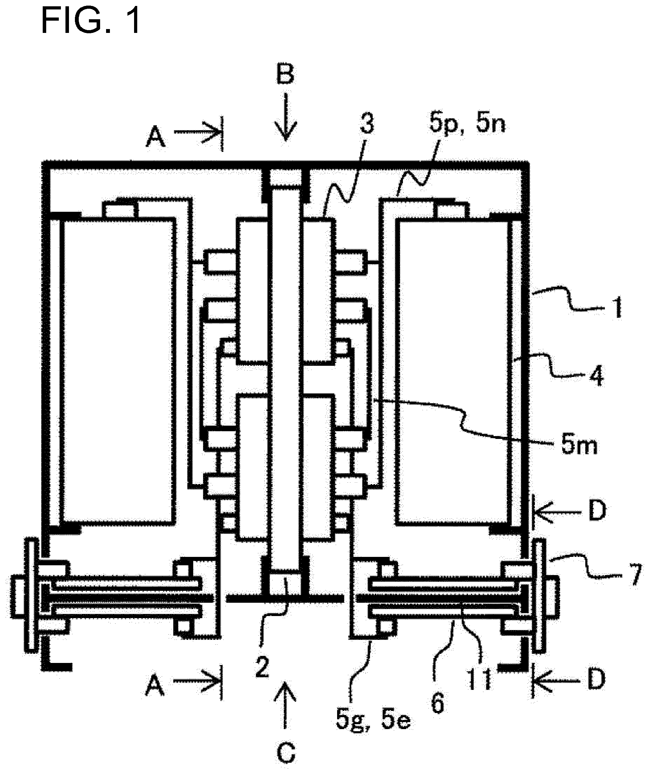

Fig. 1 shows a basic structure of a power conversion device according to the present embodiment. The power conversion device is installed in an electric vehicle such as a train or an electric car. Main constituent components of the power conversion device are a casing 1, a heat radiating plate 2, power semiconductors 3, smoothing capacitors 4, wirings 5p, 5n, 5m, 5g, and 5e, gate drive boards 6, and relay boards 7. Among them, the power semiconductors 3, the smoothing capacitors 4, the wirings 5p, 5n, 5m, 5g, and 5e, the gate drive boards 6, and the relay boards 7 are arranged on both sides of the heat radiating plate 2. Each of the wirings 5p, 5n, 5m, 5g, and 5e is collectively represented by a single line.

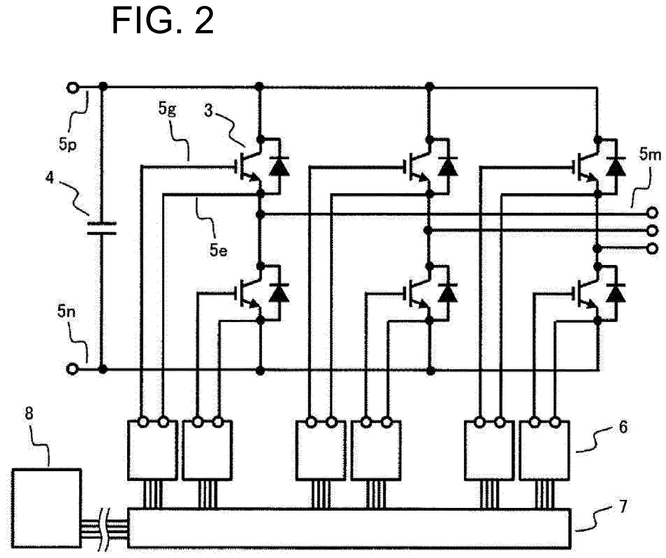

Fig. 2 shows a power conversion circuit of the power conversion device according to the present embodiment. The power conversion device is of a dual type or includes two pairs of power conversion circuits. The target power conversion circuits of the power conversion device are three-phase power conversion circuits. Each of the power conversion circuits receives a direct-current voltage applied between a P-pole wiring 5p and an N-pole wiring 5n and outputs an alternating-current voltage to an M-pole wiring 5m. The conversion from the direct-current voltage to the alternating-current voltage is performed by opening and closing operations of the power semiconductors 3. The opening and closing operations of the power semiconductors are performed in coordination with gate voltages output by the gate drive boards 6. The gate voltages are generated by the gate drive boards 6 based on a command signal transmitted from a control logical unit 8 via the relay boards 7.

Since the casing 1 has a role of holding the aforementioned main constituent components, sufficient structural strength is required. In the power conversion device, each of the casing pieces is made by performing sheet-metal processing on a SUS sheet, and the casing 1 is formed by assembling the casing pieces using bolts and nuts or by welding or the like. Since the smoothing capacitors 4 are important components in terms of the structural strength, it is necessary to determine the structure of the casing 1 in consideration of vibration isolation upon an operation of the device. An example of a vibration isolation structure is a structure in which beams for holding the smoothing capacitors 4 are bent to gain rigidity.

Both surfaces of the heating radiating plate 2 adhere to the power semiconductors 3 and the heat radiating plate 2 radiates heat generated by the power semiconductors 3 to the outside. A durable temperature range is defined for solder joint portions of the power semiconductors 3. It is necessary that the heat radiation be promoted without deviation from the durable temperature range.

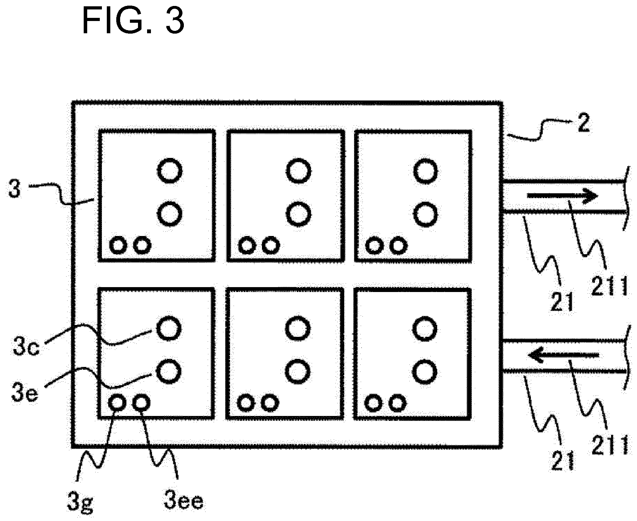

Fig. 3 shows the arrangement of the heat radiating plate and the power semiconductors when viewed from a side indicated by arrows A in Fig. 1. A cooling method of the power conversion device is a water-cooling method with high heat radiation performance. Water-cooling pipes 21 are attached to the heat radiation plate 2 as shown in Fig. 3. In the water-cooling method, cooling water 211 flows into the heat radiating plate 2 from an upstream side of the water-cooling pipes 21, passes through cooling water paths installed in the heat radiating plate 2, and flows toward a downstream side of the water-cooling pipes 21 to promote the heat radiation. As the cooling water 211, antifreeze is used to prevent freezing in many cases. In the power conversion device, a mixed liquid of water and ethylene glycol is used.

In the power conversion device, the power semiconductors 3 are arranged in two rows and three columns, as shown in Fig. 3. The arrangement in a left and right direction corresponds to U, V, and W phases of the power conversion circuits. The arrangement in a top and bottom direction corresponds to upper and lower arms of the power conversion circuits. In addition, power semiconductors 3 are arranged on a rear surface of the heat radiating plate 2.

Each of the power semiconductors 3 includes a collector terminal 3c and an emitter terminal 3e. Between these terminals, a high voltage of several hundreds to several thousands of volts is applied in a closed state and a large current of several hundreds to several thousands of amperes flows in an open state. Each of the power semiconductors 3 also includes a gate terminal 3g and an auxiliary emitter terminal 3ee. The open state and the closed state are switched based on a gate voltage applied between these terminals. As an example, the gate voltage is 7 V or higher in the open state and is lower than 7 V in the closed state. The opening and closing operations are one of reasons for the generation of heat by the aforementioned power semiconductors 3. There is a correlation in which generated heat is higher as the opening and closing operations are slower.

In the power conversion device, each of the power semiconductors 3 includes a single collector terminal 3c and a single emitter terminal 3e but may include a plurality of collector terminals 3c and a plurality of emitter terminals 3e. As advantages of including the plurality of collector terminals 3c and the plurality of emitter terminals 3e, an ampacity can be increased and internal inductance can be reduced.

In the device, IGBT elements are used as the power semiconductors 3, but other elements may be used as long as the power semiconductors perform the opening and closing operations in the same manner as described above. As an example, SiC elements may be used.

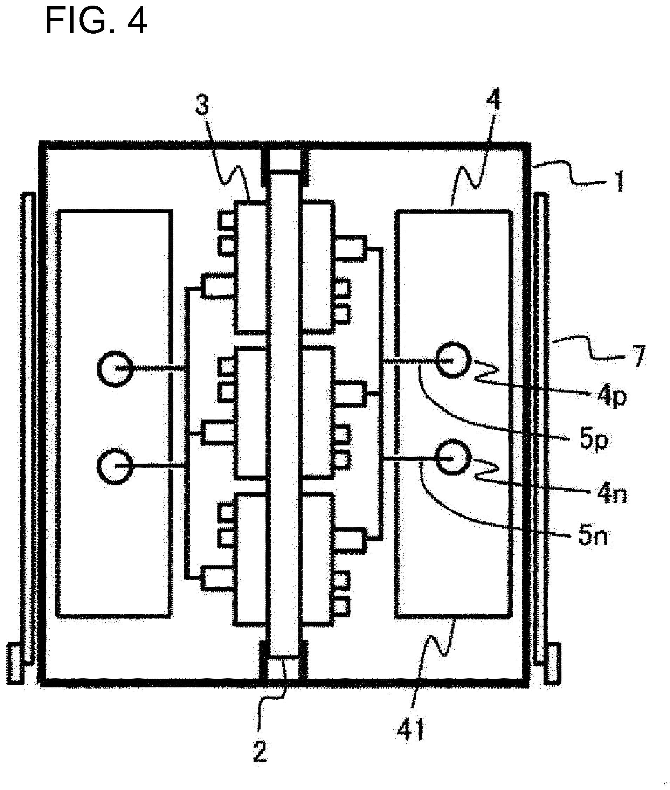

Fig. 4 shows device arrangement viewed from a side indicated by an arrow B shown in Fig. 1. The smoothing capacitors 4 are arranged on both sides of the heat radiating plate 2 in the casing 1 as shown in Fig. 1 and are electrically connected to the power semiconductors 3 via the P-pole wirings 5p and the N-pole wirings 5n. In the power conversion device, each of the smoothing capacitors 4 includes a single smoothing capacitor P-pole terminal 4p and a single smoothing capacitor N-pole terminal 4n, as shown in Fig. 4, but may include a plurality of smoothing capacitor P-pole terminals 4p and a plurality of smoothing capacitor N-pole terminals 4n. As advantages of including the plurality of smoothing capacitor P-pole terminals 4p and the plurality of smoothing capacitor N-pole terminals 4n, the ampacity can be increased and the internal inductance can be reduced.

In each of the smoothing capacitors 4, a plurality of capacitor elements are electrically connected to a smoothing capacitor P-pole terminal 4p and a smoothing capacitor N-pole terminal 4n via internal wirings. Smoothing capacitor casings 41 storing these terminals are molded with resin. The smoothing capacitor casings 41 have an electrical insulation property, insulation distances between the smoothing capacitor casings 41 and the wirings 5p, 5n, 5m, 5g, and 5e are reduced, and the power conversion device is downsized.

A main function of each of the smoothing capacitors 4 smooths a direct-current voltage applied between a P-pole wiring 5p and an N-pole wiring 5n. Normally, a direct-current voltage output from a substation or a rectifier includes a large pulsing component and cannot be used without conversion. A pulsing component is suppressed by using the smoothing capacitors 4, and the smoothed direct-current voltages are input to the power conversion circuits. As a result, operations of the power conversion circuits are stabilized. As capacitance of the smoothing capacitors 4 is larger, an effect of suppressing a pulsing component is larger.

In the power conversion device, the smoothing capacitors 4 are arranged in the vicinity of the power semiconductors 3 so that lengths of the P-pole and N-pole wirings 5p and 5n are as short as possible. If the smoothing capacitors 4 are arranged away from the power semiconductors 3, the lengths of the P-pole and N-pole wirings 5p and 5n are increased with this and wiring inductance increases . As a result, surge voltages upon the opening and closing operations of the power semiconductors 3 are high and operations of the power conversion circuits are not stable. While attention is paid to this feature, surge voltages are suppressed and the operations of the power conversion circuits are stabilized in the power conversion device.

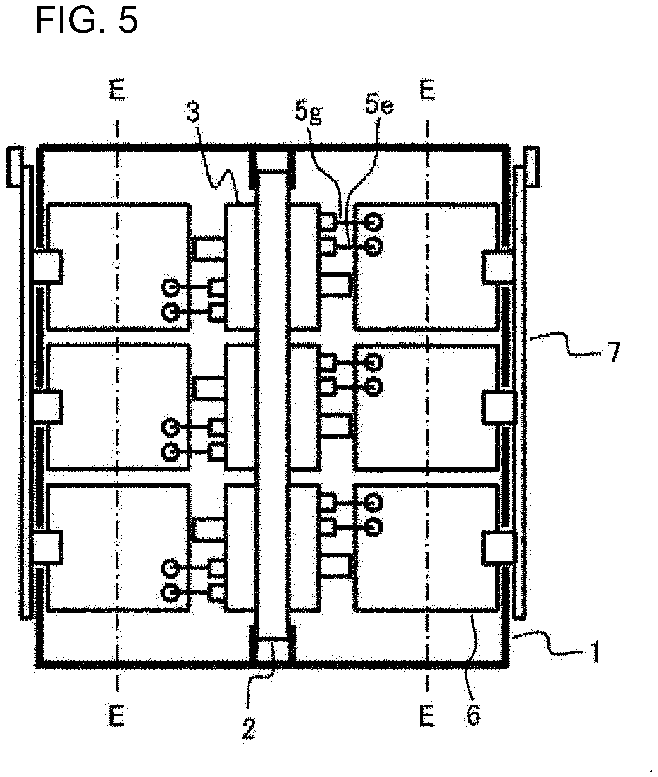

Fig. 5 shows device arrangement viewed from a side indicated by an arrow C shown in Fig. 1. As shown in Fig. 1, the gate drive boards 6 are located under the smoothing capacitors 4 in the casing 1. As shown in Fig. 5, phases of each of the gate drive boards 6 are arranged so that a direction and the order in which the phases of each of the gate drive boards 6 are arranged are the same as a direction and the order in which phases of each of the power semiconductors 3 are arranged. The gate drive boards 6 are electrically connected to the power semiconductors 3 via the G-pole wirings 5g and the E-pole wirings 5e.

The gate drive boards 6 are divided into high-potential portions and low-potential portions based on division lines E shown in Fig. 5. The high-potential portions are arranged on a side closer to the power semiconductors 3, while the low-potential portions are arranged on a side farther away from the power semiconductors 3. Insulating transformers or the like are used to insulate the high-potential portions from the low-potential portions, for example. It is necessary that the high-potential portions be insulated and separated from the low-potential portions in order to transmit and receive a control signal to and from the control logical unit 8 that operates at a low potential. In the power conversion device, regions occupied by the low-potential portions are large in the casing 1 since the high-potential portions of the gate drive boards 6 are concentrated in the vicinity of the power semiconductors 3 that operate at a high potential. Since insulation distances required for the low-potential portions are significantly shorter than those required for the high-potential portions, the power conversion device can be easily downsized.

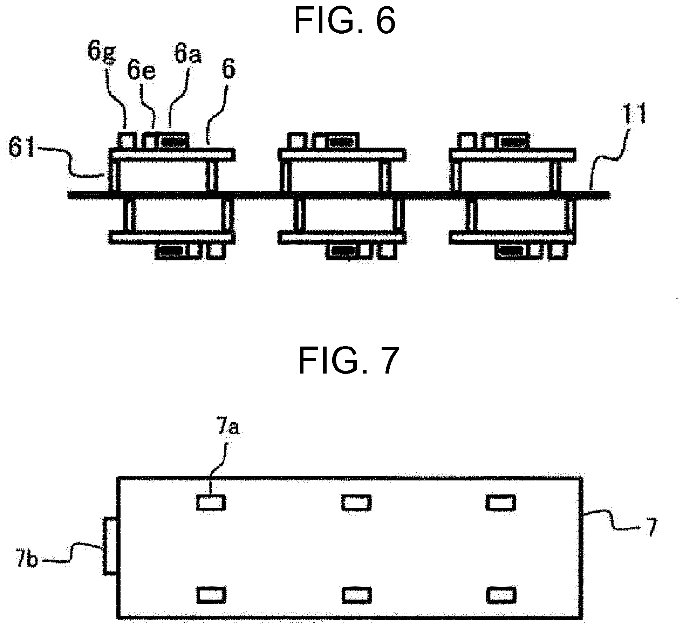

Fig. 6 shows device arrangement viewed from a side indicated by arrows D in Fig. 1. As shown in Fig. 6, each of the gate drive boards 6 includes a gate drive board G-pole terminal 6g connected to a G-pole wiring 5g, a gate drive board E-pole terminal 6e connected to an E-pole wiring 5e, and a gate drive board connector 6a connected to a relay board 7. In addition, the gate drive boards 6 are fixed to a casing piece 11 via insulating spacers 61. The insulating spacers 11 are molded with a resin material or the like.

Since the casing piece 11 is at a ground potential and the portions of the gate drive boards 6 are at a high potential, the casing piece 11 and the gate drive boards 6 need to be arranged with appropriate insulation distances in consideration of insulation reliability, and lengths of the insulating spacers 61 are determined based on the insulation distances. In the power conversion device, the lengths are 20 mm. Since differences between potentials of the gate drive boards 6 adjacent to each other are large, the casing piece 11 and the gate drive boards 6 need to be arranged with the appropriate insulation distances between the casing piece 11 and the gate drive boards 6 in consideration of the insulation reliability. In the power conversion device, the insulation distances are 20 mm.

Since the gate drive boards 6 are fixed to both surfaces of the casing piece 11, the casing piece 11 can be constituted by a single plate material. Thus, the casing piece 11 and the structure of the casing 1 can be simplified and the cost of manufacturing them can be reduced.

Fig. 7 shows a configuration of each of the relay boards installed in the power conversion device according to the present embodiment. A plurality of gate drive boards 6 are collectively connected to each relay board 7 shown in Fig. 7. Each of the relay boards 7 includes the same number of relay board connectors 7a as the number of gate drive boards 6 and includes one or more control signal input and output units 7b for receiving and outputting a control signal in relation with the control logical unit 8. The gate drive board connectors 6a included in the gate drive boards 6 and the relay board connectors 7a included in the relay boards 7 have relationships between males and females. The relay boards 7 are held by engaging the two. When the holding by only the connectors causes insufficient structural strength, the relay boards 7 may be fixed to the casing piece 11 via insulating spacers or the like.

As described above, the lengths of the insulating spacers 61 existing between the gate drive boards 6 and the casing piece 11 tend to increase from the perspective of an insulation property, and the deflection of the insulating spacers 61 increases with the increases in the lengths and may cause a reduction in the structural strength. However, since the connectors of the plurality of gate drive boards 6 are collectively connected to the relay boards 7 in the structure, the power conversion device in which the deflection of the insulating spacers 61 is suppressed and the structural strength is improved can be provided.

Electronic components implemented on the gate drive boards 6 and solder portions attached to the electronic components may be adversely affected by heat and may cause a failure in a circuit operation. Examples of a cause of the generation of heat are heat radiation by the heat radiating plate 2, heat generated by the power semiconductors 3, heat generated by the smoothing capacitors 4, and heat generated by the wirings 5p, 5n, 5m, 5g, and 5e. The heat has a tendency to flow upward. In the power conversion device, the gate drive boards 6 are arranged at lowest portions of the casing 1 and thus are not exposed to the aforementioned heat. As a result, the gate drive boards 6 are not affected by the heat, and circuit operations are stabilized.

According to the present embodiment, the circuit operations are stabilized, the insulation reliability is improved, the manufacturing cost is reduced, and the compact power conversion device can be provided.

### Second Embodiment

The present embodiment is different from the first embodiment in that insulating plates exist between gate drive boards 6 and the casing piece 11 and between the gate drive boards 6 adjacent to each other. Features different from the first embodiment are mainly described below.

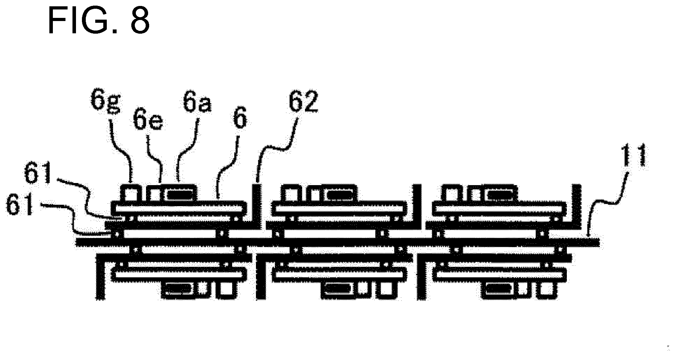

Fig. 8 shows the arrangement of the gate drive boards in a power conversion device according to the present embodiment. As shown in Fig. 8, the gate drive boards 6 are fixed to the insulating plates 62 via insulating spacers 61, and the insulating plates 62 are fixed to the casing piece 11 via insulating spacers 61. The insulating plates 62 are molded with a resin material or the like.

The casing piece 11 is at the ground potential and portions of the gate drive boards 6 are at a high potential. However, since the insulating plates 62 exist between the two, distances between the casing piece 11 and the gate drive boards 6 can be reduced relative to the first embodiment. In the present embodiment, the distances between the casing piece 11 and the insulating plates 62 are 5 mm, distances between the insulating plates 62 and the gate drive boards 6 are 5 mm, and thicknesses of the insulating plates 62 are 1.5 mm. Thus, distances between the casing piece 11 and the gate drive boards 6 are 11. 5 mm. Since the distances on each side of the casing piece 11 can be reduced by 8.5 mm relative to the first embodiment, the distances on both sides of the casing piece 11 can be reduced by 17 mm relative to the first embodiment. On the other hand, the insulating spacers need to be appropriately arranged to sufficiently secure creepage distances for insulation between the casing piece 11 and the gate drive boards 6.

Differences between potentials of the gate drive boards 6 adjacent to each other are large, but the insulating plates 62 exist between the two. Thus, distances between the gate drive boards 6 adjacent to each other can be reduced relative to the first embodiment. In the present embodiment, the distances between the gate drive boards 6 and the insulating plates 62 are 5 mm, and the thicknesses of the insulating plates 62 are 1.5 mm. Thus, the distances between the gate drive boards 6 adjacent to each other are 11.5 mm. Since the distance between a pair of gate drive boards 6 adjacent to each other can be reduced by 8.5 mm relative to the first embodiment, distances between gate drive boards 6 adjacent to each other can be reduced by 17 mm as a whole relative to the first embodiment.

According to the present embodiment, a power conversion device smaller than that described in the first embodiment can be provided.

### Third Embodiment

In a present embodiment, a single-type power conversion device that includes a pair of power conversion circuits is provided, unlike the first embodiment. Features different from the first embodiment are mainly described below.

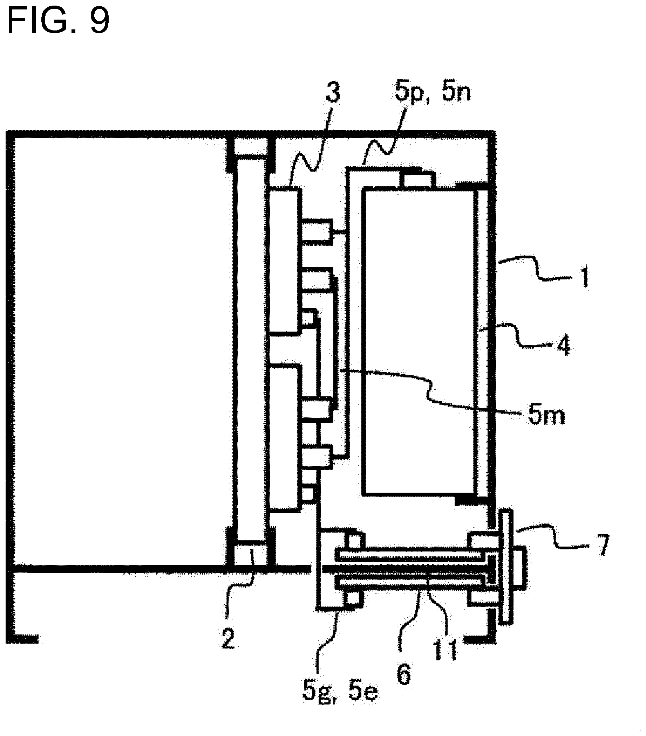

Fig. 9 shows a basic structure of the power conversion device according to the present embodiment. Main constituent components of the power conversion device are a casing 1, a heat radiating plate 2, power semiconductors 3, smoothing capacitors 4, wirings 5p, 5n, 5m, 5g, and 5e, gate drive boards 6, and a relay board 7. Among them, the power semiconductors 3, the smoothing capacitor 4, the wirings 5p, 5n, 5m, 5g, and 5e, the gate drive board 6, and the relay board 7 are arranged on one side of the heat radiating plate 2. Optionally, but beyond the scope of the claims, they may be arranged on the right side of the heat radiating plate 2 in Fig. 9, but may be arranged on the left side of the heat radiating plate 2.

In the case where a requested ampacity is relatively small, when the power conversion device according to the first embodiment is applied, the ampacity may be excessive. Thus, a power conversion device in which the ampacity is reduced by half is requested. The power conversion device according to the present embodiment can satisfy the request by removing constituent components described in the first embodiment without new design and manufacturing.

According to the present embodiment, in providing the power conversion device in which the ampacity is reduced by half relative to the first embodiment, time periods for the design and manufacturing and the cost can be reduced.

### Fourth Embodiment

In a present embodiment, a smoothing capacitor is additionally installed, unlike the third embodiment. Features different from the third embodiment are mainly described below.

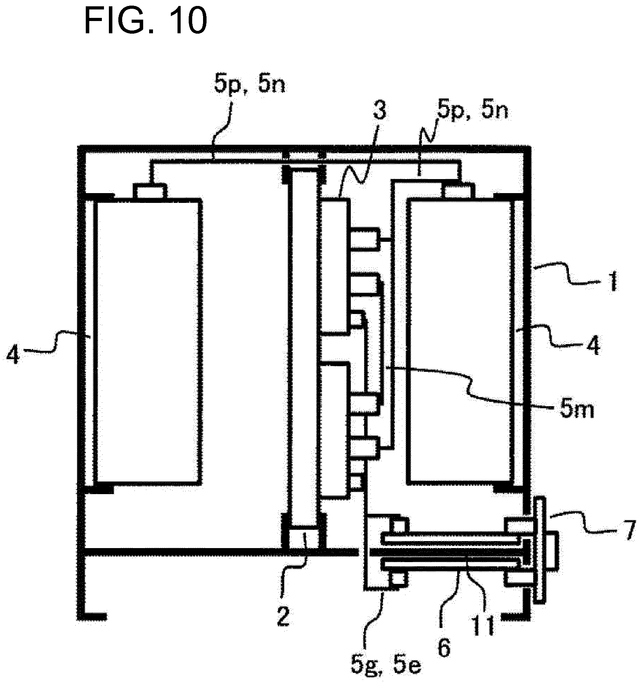

Fig. 10 shows a basic structure of a power conversion device according to the present embodiment. Main constituent components of the power conversion device are a casing 1, a heat radiating plate 2, power semiconductors 3, smoothing capacitors 4, wirings 5p, 5n, 5m, 5g, and 5e, gate drive boards 6, and a relay board 7. Among them, the power semiconductors 3, the wirings 5p, 5n, 5m, 5g, and 5e, the gate drive boards 6, and the relay board 7 are arranged on one side of the heat radiating plate 2. Optionally, but beyond the scope of the claims, they may be arranged on the right side of the heat radiating plate 2 in Fig. 10, but may be arranged on the left side of the heat radiating plate 2.

The smoothing capacitors 4 are arranged on both sides of the heat radiating plate 2 and electrically connected to each other via the P-pole wiring 5p and the N-pole wiring 5n. The smoothing capacitors 4 may not be the same, and outer shapes of the smoothing capacitors 4 may be enlarged as far as the smoothing capacitors 4 are stored in the casing 1. In this case, the structure of the casing 1 needs to be determined in consideration of vibration isolation upon an operation of the device.

As advantages of additionally installing the smoothing capacitor 4 relative to the third embodiment, capacitance can be large, an ampacity can be large, and substantial internal inductance can be reduced. These effects are described in the first embodiment.

According to the present embodiment, the compact power conversion device in which a circuit operation is more stabilized than the third embodiment can be provided.

### Fifth Embodiment

In a present embodiment, a power conversion device that is a single-phase conversion circuit is provided. Features different from the first embodiment are mainly described below.

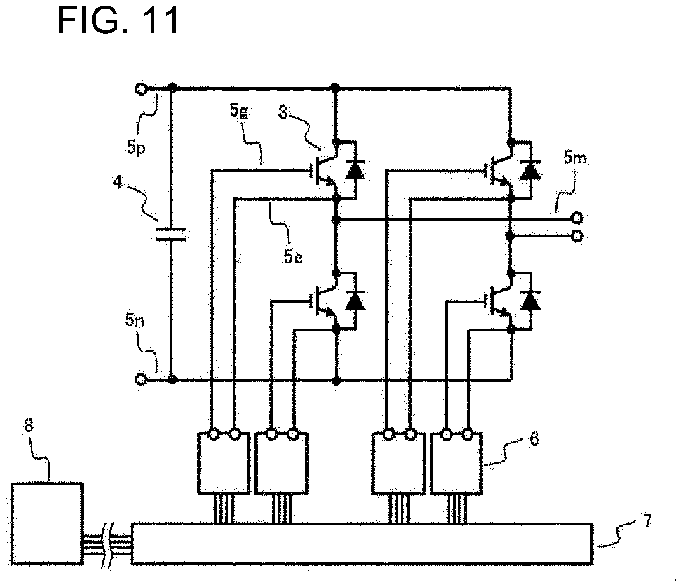

Fig. 11 shows the power conversion circuit of the power conversion device according to the present embodiment. The power conversion device according to the present embodiment may be of a dual type or of a single type. The target power conversion circuit of the power conversion device is a single-phase conversion circuit. The power conversion circuit receives a direct-current voltage applied between a P-pole wiring 5p and an N-pole wiring 5n and outputs an alternating-current voltage to M-pole wirings 5m. The power conversion circuit receives an alternating-current voltage applied between the M-pole wirings 5m and outputs a direct-current voltage between the P-pole wiring 5p and the N-pole wiring 5n.

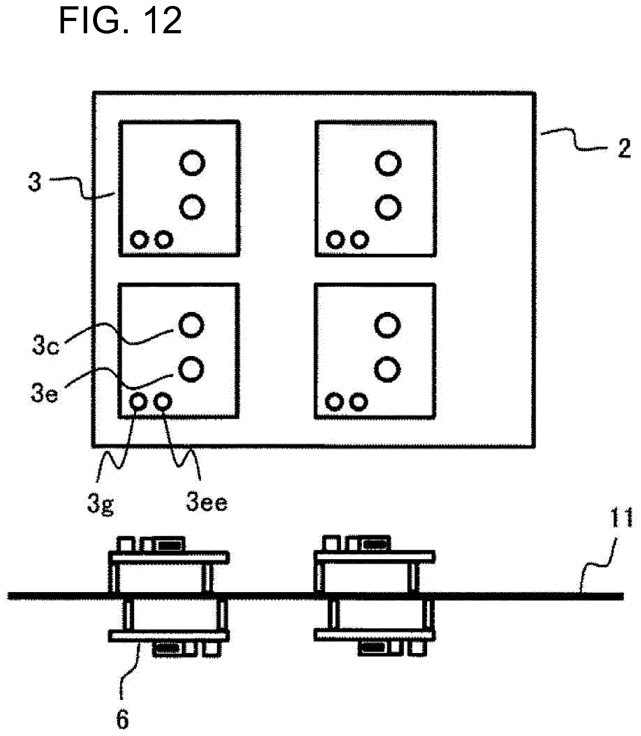

Fig. 12 shows the arrangement of power semiconductors and gate drive boards in the power conversion device according to the present embodiment. In the power conversion device, the power semiconductors 3 are arranged in 2 rows and 2 columns as shown in Fig. 12. The arrangement in a left and right direction corresponds to U and V phases of the power conversion circuit. The arrangement in a top and bottom direction corresponds to upper and lower arms of the power conversion circuit. As shown in Fig. 12, phases of each of the gate drive boards 6 are arranged so that a direction and the order in which the phases of each of the gate drive boards 6 are arranged are the same as a direction and the order in which phases of each of the power semiconductors 3 are arranged.

In the case where a single-phase load is controlled or an input alternating-current voltage is rectified and a direct-current voltage to be output is obtained, the power conversion device according to the first embodiment is not applied and the power conversion device constituting the single-phase power conversion circuit is requested. The corresponding power conversion device can be provided by changing the arrangement of the power semiconductors 3 and the gate drive boards 6 relative to the first embodiment without new design and manufacturing in the power conversion device.

According to the present embodiment, in providing the power conversion device including the single-phase conversion circuit with which the three-phase conversion circuits according to the first embodiment are replaced, time periods for the design and manufacturing and the cost can be reduced.

### Sixth Embodiment

In a present embodiment, upper and lower arms of a power conversion circuit are constituted by a single power semiconductor 3, unlike the first embodiment. Features different from the first embodiment are mainly described below.

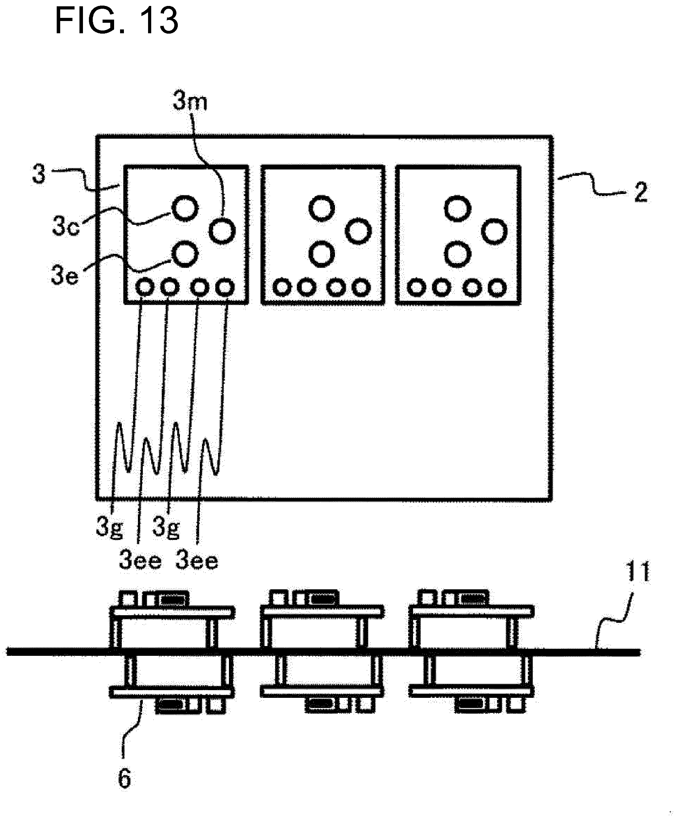

Fig. 13 shows the arrangement of power semiconductors and gate drive boards in a power conversion device according to the present embodiment. The case where the target power conversion circuit is a three-phase conversion circuit is described below. In the power conversion device, the power semiconductors 3 are arranged in one row and three columns as shown in Fig. 13. The arrangement in a left and right direction corresponds to U, V, and W phases of the power conversion circuit. The upper and lower arms of the power conversion circuit are constituted by the single power semiconductor 3. As shown in Fig. 13, phases of each of the gate drive boards 6 are arranged so that a direction and the order in which the phases of each of the gate drive boards 6 are arranged are the same as a direction and the order in which phases of each of the power semiconductors 3 are arranged.

Each of the power semiconductors 3 has not only a collector 3c and an emitter terminal 3e but also an alternating-current output terminal 3m. Each of the power semiconductors 3 also has a gate terminal 3g and an emitter terminal 3ee for the upper arm and has a gate terminal 3g and an auxiliary emitter terminal 3ee for the lower arm.

As advantages of constituting the upper and lower arms of the power conversion circuit by the single power semiconductor 3, the number of power semiconductors 3 to be installed can be reduced by half, the structure of P-pole, N-pole, and M-pole wirings 5p, 5n, and 5m connected to the power semiconductors 3 can be simplified. The former effect enables the manufacturing cost to be reduced and the latter effect enables regions occupied by the P-pole, N-pole, and M-pole wirings 5p, 5n, and 5m to be reduced and enables the outer shape to be downsized.

According to the present embodiment, the compact power conversion device manufactured with low cost relative to the first embodiment can be provided.

### Seventh Embodiment

In a present embodiment, a cooling method is an air-cooling method, unlike the first embodiment. Features different from the first embodiment are mainly described below.

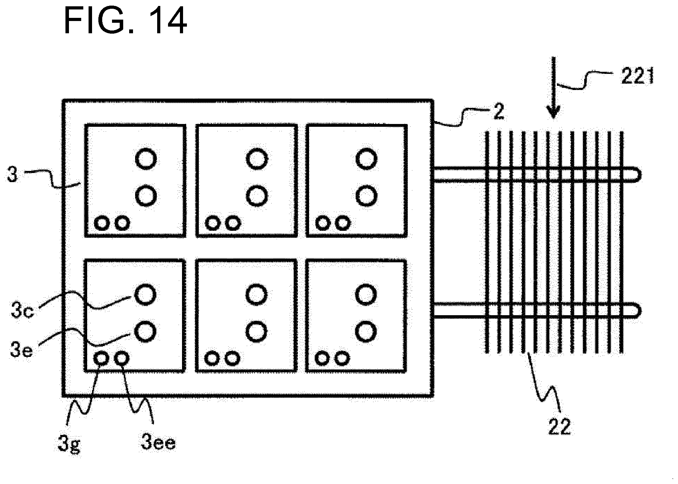

Fig. 14 shows the arrangement of a heat radiating plate and power semiconductors in a power conversion device according to the seventh embodiment. The cooling method of the power conversion device is the air-cooling method. A cooling fin 22 is attached to the heat radiating plate 2, as shown in Fig. 14. In the air-cooling method, heat radiation is promoted by causing cooling air 211 to cross the cooling fin 22. As the cooling air 221, counter air when the device is installed in a vehicle or forced air blown by a blower may be used. The heat radiating plate 2 and the cooling fin 22 are connected to each other by heat pipes with excellent thermal conductivity.

Generally, heat radiation performance of the air-cooling method is lower than heat radiation performance of the water-cooling method, but the cost of manufacturing a cooling system for the air-cooling method is significantly reduced, compared with the water-cooling method. When a natural air-cooling method using natural convection around the cooling fin 22 instead of the cooling air 211 is used in the air-cooling method, the heat radiation performance is further lower, but there is no concern about damage and corrosion caused by the exposure of the cooling fin 22 to external air, a blower is not required, and the cost of manufacturing the cooling system is further reduced.

According to the seventh embodiment, the compact power conversion device manufactured with reduced cost relative to the first embodiment can be provided.

### List of Reference Signs

1 ··· Casing, 2 ··· Heat radiating plate, 3 ··· Power semiconductor, 3c ··· Collector terminal, 3e ··· Emitter terminal, 3ee ··· Auxiliary emitter terminal, 3g ··· Gate terminal, 3m ··· Alternating-current output terminal, 4 ··· Smoothing capacitor, 4p ··· Smoothing capacitor P-pole terminal, 4n ··· Smoothing capacitor N-pole terminal, 5p ··· P-pole wiring, 5n ··· N-pole wiring, 5m ··· M-pole wiring, 5g ··· G-pole wiring, 5e ··· E-pole wiring, 6 ··· Gate drive board, 6a ··· Gate drive board connector, 6g ··· Gate drive board G-pole terminal, 6e ··· Gate drive board E-pole terminal, 7 ··· Relay board, 7a ··· Relay board connector, 7b ··· Control signal input and output unit, 8 ··· Control logical unit, 11 ··· Casing piece, 21 ··· Water-cooling pipe, 22 ··· Cooling fin, 41 ··· Smoothing capacitor casing, 61 ··· Insulating spacer, 62 ··· Insulating plate, 211 ··· Cooling water, 221 ··· Cooling air

## Claims

1. A power conversion device comprising:
a plurality of power semiconductors(3) arranged in a casing(1) and constituting upper and lower arms of phases of a power conversion circuit;
a heat radiating plate(2) arranged in the casing(1) and having both surfaces on which the plurality of power semiconductors(3) are installed;
a plurality of smoothing capacitors (4) arranged in the casing (1) and electrically connected to the plurality of power semiconductors (3) ; and
a plurality of gate drive boards(6) arranged in the casing(1) and configured to receive and output a control signal from and to the plurality of power semiconductors(3);
wherein the plurality of smoothing capacitors(4) are arranged on both sides of the heat radiating plate(2),
**characterized in that**:
the gate drive boards(6) are arranged under the power semiconductors(3), the heat radiating plate(2), and the smoothing capacitors(4), and
the gate drive boards (6) are divided into high-potential portions and low-potential portions, the high-potential portions are arranged on a side closer to the power semiconductors (3), and the low-potential portions are arranged on a side farther away from the power semiconductors(3) .

2. The power conversion device according to claim 1,
wherein a water-cooling pipe (21) is attached to the heat radiating plate(2) and causes cooling water to flow into and out of the heat radiating plate(2).

3. The power conversion device according to claim 1,
wherein a cooling fin(22) is attached to the heat radiating plate(2), and cooling air crosses the cooling fin(22).

4. The power conversion device according to claim 1,
wherein a cooling fin(22) is attached to the heat radiating plate(2), and natural convection occurs around the cooling fin(22).

5. The power conversion device according to any of claims 1 to 4,
wherein the plurality of gate drive boards(6) are held on both surfaces of a plate material(11).

6. The power conversion device according to claim 5,
wherein insulating members(62) are arranged between the plurality of gate drive boards (6) and the plate material (11) and between the gate drive boards(6) adjacent to each other.

7. The power conversion device according to any of claims 1 to 6,
wherein the gate drive boards(6) have connectors(6a) electrically connected to a relay board(7), the relay board(7) has a plurality of connectors(7a) electrically connected to the plurality of gate drive boards (6), and the plurality of gate drive boards (6) are collectively connected to the relay board(7).

8. The power conversion device according to claim 7,
wherein the relay board(7) is held by the casing(1).

9. The power conversion device according to any of claims 1 to 8,
wherein the upper and lower arms of the power conversion circuit are constituted by a single power semiconductor(3).

10. The power conversion device according to any of claims 1 to 9,
wherein casings(41) of the smoothing capacitors(4) are molded with resin.

11. An electric vehicle comprising the power conversion device according to any of claims 1 to 10.

## Patentansprüche

1. Leistungswandlungsvorrichtung, die Folgendes umfasst:
eine Vielzahl von Leistungshalbleitern (3), die in einem Gehäuse (1) angeordnet sind und obere und untere Zweige von Phasen eines Leistungswandlerschaltkreises ausbilden;
eine wärmeabstrahlende Platte (2), die in dem Gehäuse (1) angeordnet ist und beide Flächen aufweist, auf denen die Vielzahl von Leistungshalbleitern (3) montiert ist;
eine Vielzahl von Glättungskondensatoren (4), die in dem Gehäuse (1) angeordnet sind und elektrisch mit der Vielzahl von Leistungshalbleitern (3) verbunden sind; und
eine Vielzahl von Gate-Ansteuer-Platinen (6), die in dem Gehäuse (1) angeordnet sind und ausgelegt sind, um ein Steuerungssignal von der Vielzahl von Leistungshalbleitern (3) zu empfangen und an diese auszugeben;
wobei die Vielzahl von Glättungskondensatoren (4) auf beiden Seiten der wärmeabstrahlenden Platte (2) angeordnet sind,
**dadurch gekennzeichnet, dass**:
die Gate-Ansteuer-Platinen (6) unterhalb der Leistungshalbleiter (3), der wärmeabstrahlenden Platte (2) und der Glättungskondensatoren (4) angeordnet sind, und
die Gate-Ansteuer-Platinen (6) in Abschnitte mit hohem Potential und Abschnitte mit geringem Potential unterteilt sind, wobei die Abschnitte mit hohem Potential auf einer Seite angeordnet sind, die näher zu den Leistungshalbleitern (3) liegt, und die Abschnitte mit geringem Potential auf einer Seite angeordnet sind, die weiter von den Leistungshalbleitern (3) entfernt liegt.

2. Leistungswandlungsvorrichtung nach Anspruch 1, wobei ein Wasserkühlrohr (21) an der wärmeabstrahlenden Platte (2) befestigt ist und bewirkt, dass Kühlwasser in die und aus der wärmeabstrahlenden Platte (2) strömt.

3. Leistungswandlungsvorrichtung nach Anspruch 1, wobei eine Kühlrippe (22) an der wärmeabstrahlenden Platte (2) befestigt ist und Kühlluft die Kühlrippe (22) durchquert.

4. Leistungswandlungsvorrichtung nach Anspruch 1, wobei eine Kühlrippe (22) an der Wärmeabstrahlplatte (2) befestigt ist und natürliche Konvektion rund um die Kühlrippe (22) auftritt.

5. Leistungswandlungsvorrichtung nach einem der Ansprüche 1 bis 4, wobei die Vielzahl von Gate-Ansteuer-Platinen (6) auf beiden Flächen eines Plattenmaterials (11) gehalten ist.

6. Leistungswandlungsvorrichtung nach Anspruch 5, wobei Isolierelemente (62) zwischen der Vielzahl von Gate-Ansteuer-Platinen (6) und dem Plattenmaterial (11) sowie zwischen benachbarten Gate-Ansteuer-Platinen (6) angeordnet sind.

7. Leistungswandlungsvorrichtung nach einem der Ansprüche 1 bis 6, wobei die Gate-Ansteuer-Platinen (6) Verbinder (6a) aufweisen, die elektrisch mit einer Relaisplatine (7) verbunden sind, wobei die Relaisplatine (7) eine Vielzahl von Verbindern (7a) aufweist, die elektrisch mit der Vielzahl von Gate-Ansteuer-Platinen (6) verbunden sind und die Vielzahl von Gate-Ansteuer-Platinen (6) zusammen mit der Relais-Platine (7) verbunden sind.

8. Leistungswandlungsvorrichtung nach Anspruch 7, wobei die Relais-Platine (7) durch das Gehäuse (1) gehalten ist.

9. Leistungswandlungsvorrichtung nach einem der Ansprüche 1 bis 8, wobei die oberen und unteren Zweige des Leistungswandlerschaltkreises durch einen einzelnen Leistungshalbleiter (3) ausgebildet sind.

10. Leistungswandlungsvorrichtung nach einem der Ansprüche 1 bis 9, wobei Gehäuse (41) der Glättungskondensatoren (4) mit Harz geformt sind.

11. Elektrisches Fahrzeug, das eine Leistungswandlungsvorrichtung nach einem der Ansprüche 1 bis 10 umfasst.

## Revendications

1. Dispositif de conversion de puissance, comprenant :
une pluralité de semi-conducteurs de puissance (3) agencés dans un boîtier (1) et constituant des bras supérieur et inférieur de phases d'un circuit de conversion de puissance ;
une plaque de rayonnement de chaleur (2) agencée dans le boîtier (1) et présentant deux surfaces sur lesquelles la pluralité de semi-conducteurs de puissance (3) sont installés ;
une pluralité de condensateurs de lissage (4) agencés dans le boîtier (1) et connectés électriquement à la pluralité de semi-conducteurs de puissance (3) ; et
une pluralité de cartes d'attaque de grille (6) agencées dans le boîtier (1) et configurées pour recevoir un signal de commande en provenance de la pluralité de semi-conducteurs de puissance (3), et délivrer en sortie un signal de commande à ceux-ci ;
dans lequel la pluralité de condensateurs de lissage (4) sont agencés des deux côtés de la plaque de rayonnement de chaleur (2),
**caractérisé en ce que** :
les cartes d'attaque de grille (6) sont agencées sous les semi-conducteurs de puissance (3), la plaque de rayonnement de chaleur (2), et les condensateurs de lissage (4), et
les cartes d'attaque de grille (6) sont divisées en parties à potentiel élevé et parties à potentiel faible, les parties à potentiel élevé sont agencées sur un côté plus proche des semi-conducteurs de puissance (3), et les parties à potentiel faible sont agencées sur un côté plus éloigné des semi-conducteurs de puissance (3).

2. Dispositif de conversion de puissance selon la revendication 1,
dans lequel un tuyau de refroidissement d'eau (21) est fixé à la plaque de rayonnement de chaleur (2) et amène un de l'eau de refroidissement à s'écouler dans et hors de la plaque de rayonnement de chaleur (2).

3. Dispositif de conversion de puissance selon la revendication 1,
dans lequel une ailette de refroidissement (22) est fixée à la plaque de rayonnement de chaleur (2), et de l'air de refroidissement traverse l'ailette de refroidissement (22) .

4. Dispositif de conversion de puissance selon la revendication 1,
dans lequel une ailette de refroidissement (22) est fixée à la plaque de rayonnement de chaleur (2), et une convection naturelle se produit autour de l'ailette de refroidissement (22).

5. Dispositif de conversion de puissance selon l'une quelconque des revendications 1 à 4,
dans lequel la pluralité de cartes d'attaque de grille (6) sont maintenues sur les deux surfaces d'un matériau de plaque (11).

6. Dispositif de conversion de puissance selon la revendication 5,
dans lequel des éléments isolants (62) sont agencés entre la pluralité de cartes d'attaque de grille (6) et le matériau de plaque (11) et entre les cartes d'attaque de grille (6) adjacentes les unes aux autres.

7. Dispositif de conversion de puissance selon l'une quelconque des revendications 1 à 6,
dans lequel les cartes d'attaque de grille (6) ont des connecteurs (6a) connectés électriquement à une carte de relais (7), la carte de relais (7) a une pluralité de connecteurs (7a) connectés électriquement à la pluralité de cartes d'attaque de grille (6), et la pluralité de cartes d'attaque de grille (6) sont connectées collectivement à la carte de relais (7).

8. Dispositif de conversion de puissance selon la revendication 7,
dans lequel la carte de relais (7) est maintenue par le boîtier(1).

9. Dispositif de conversion de puissance selon l'une quelconque des revendications 1 à 8,
dans lequel les bras supérieur et inférieur du circuit de conversion de puissance sont constitués d'un semiconducteur de puissance unique (3).

10. Dispositif de conversion de puissance selon l'une quelconque des revendications 1 à 9,
dans lequel des boîtiers (41) des condensateurs de lissage (4) sont moulés avec de la résine.

11. Véhicule électrique comprenant le dispositif de conversion de puissance selon l'une quelconque des revendications 1 à 10.
